# EUROPÄISCHE PATENTANMELDUNG

(11) **EP 4 738 174 A1**
(43) Veröffentlichungstag der Anmeldung: **06.05.2026**
(21) Anmeldenummer: 25209272.1
(22) Anmeldetag: 16.10.2025
(51) Int. Cl.: G06F 30/12, G06F 30/17

(54) **BAUTEILELEMENT EINES 3D-CAD-PROGRAMMS, CAD-STRUKTUR MIT EINEM BAUTEILELEMENT UND VERFAHREN ZUM ERSTELLEN EINER CAD-STRUKTUR**

(30) Priorität: 30.10.2024 DE 102024131767
(71) Anmelder: SSF Ingenieure AG, 80807 München (DE)
(72) Erfinder: Immel, Christian, 81671 München (DE)
(74) Vertreter: Beckord & Niedlich Patentanwälte PartG mbB

(57) **Zusammenfassung**

Die Erfindung betrifft ein Bauteilelement (2) eines 3D CAD-Programms umfassend eine Anzahl von Ankerpunkten (A) und zumindest ein Informationselement (4) in Form einer Anzahl von geometrischen CAD-Bauteilen (3), dessen Position relativ zu zumindest einem der betreffenden Ankerpunkte (A) einstellbar festgelegt ist, wobei das Bauteilelement (2) funktionell dazu ausgelegt ist, mit seiner Anzahl von Ankerpunkten (A) mit Punkten anderer CAD-Bauteile (3) derart verankert zu werden, dass Änderungen der Position eines der Punkte der CAD-Bauteile mit einer entsprechenden Änderung der Position des mit diesem Punkt gekoppelten Ankerpunktes (A) einhergeht. Des Weiteren umfasst die Erfindung eine CAD-Struktur und ein Verfahren.

## Beschreibung

Die Erfindung betrifft ein Bauteilelement eines 3D-CAD-Programms, eine CAD-Struktur und ein Verfahren zur Erstellung einer CAD-Struktur.

Bei der Erstellung virtueller Objekte in einem CAD-Programm (CAD: "Computer Aided Design", also computerunterstütztes Design) ist es häufig gewünscht oder erforderlich, einem Objekt Bezeichnungen oder Bemaßungen hinzuzufügen, die nicht Teil des Objektes selbst sind, aber Informationen über dieses Objekt liefern. Dazu stehen in CAD-Programmen in der Regel vorgefertigte Funktionalitäten zur Verfügung.

Beispielsweise erlauben es viele CAD-Programme, dass ein Benutzer die Funktion "Bemaßung" anwählt und in einem Objekt zwei Punkte auswählt, oftmals mit der Hilfe von Schnittebenen. Zwischen den beiden Punkten wird dann der Abstand, oftmals bezüglich einer Koordinatenachse, ermittelt und angezeigt, wobei auch die Art der Anzeige von dem Benutzer gewählt werden kann, z.B. durch Auswahl eines dritten Punktes.

Eine Bemaßung stellt dabei ein spezielles Objekt des CAD-Programms dar, das im Grunde unabhängig von der bemaßten Strecke ist und lediglich deren Maß angibt. Es ist keine dynamische Darstellung dieser Bemaßung möglich. Zwar mag sich ein Maß ändern, wenn sich die bemaßte Struktur ändert, jedoch ist eine dynamische Darstellung des Maßes nicht möglich.

Es ist eine Aufgabe der vorliegenden Erfindung, ein Bauteilelement eines 3D-CAD-Programms, eine CAD-Struktur und ein Verfahren zur Erstellung einer CAD-Struktur anzugeben, mit denen die oben beschriebenen Nachteile vermieden werden.

Diese Aufgabe wird durch ein Bauteilelement gemäß Patentanspruch 1, eine CAD-Struktur gemäß Patentanspruch 8 und ein Verfahren gemäß Patentanspruch 10 gelöst.

Ein erfindungsgemäßes Bauteilelement eines 3D-CAD-Programms umfasst eine Anzahl von Ankerpunkten und zumindest ein Informationselement in Form einer Anzahl von geometrischen CAD-Bauteilen, dessen Position relativ zu zumindest einem der betreffenden Ankerpunkte einstellbar festgelegt ist, wobei das Bauteilelement funktionell dazu ausgelegt ist, mit seiner Anzahl von Ankerpunkten mit Punkten anderer CAD-Bauteile derart verankert zu werden, dass Änderungen der Position eines der Punkte der CAD-Bauteile mit einer entsprechenden Änderung der Position des mit diesem Punkt gekoppelten Ankerpunktes einhergeht.

Die Erfindung liegt allgemein im technischen Bereich des CAD ("Computer Aided Design"). Mangels allgemein gültiger Definitionen gelten im Folgenden die nun erläuterten Begriffe:
Mit "CAD" wird in der Regel ein Objekt aus vorgegebenen oder eigens generierten Basisobjekten erstellt. Die Basisobjekte können eindimensional, also eine Linie, zweidimensional, also eine Fläche oder dreidimensional, also ein Körper sein. Generell kann ein Basisobjekt eine Anzahl, insbesondere eine Mehrzahl, von Punkten im Raum sein. Regelmäßig werden im CAD standardisierte Basisobjekte zur Verfügung gestellt, z.B. Quader, Zylinder, Kugel, Keil, Kegel, Torus, Fläche, Linie, Spirale, Helix oder Spline. Zusätzlich können Basisobjekte oft manuell erstellt werden, z.B. als Extrusionskörper aus einer manuell erstellten Fläche.

Ein in einem CAD-Prozess erstellter Körper wird im Folgenden als "CAD-Struktur" bezeichnet und ist im Grunde ein von einem Benutzer mittels des CAD-Programms erstelltes Objekt.

Als "CAD-Bauteil" wird ein Basisobjekt bezeichnet, aus dem eine CAD-Struktur gefertigt werden kann. CAD-Bauteile können die obigen Linien (wie z.B. gerade Linien, Spirale, Helix oder Spline), Flächen oder Körper (wie z.B. Quader, Zylinder, Kegel, Ellipsoid, Kugel, Torus, Pyramide oder Prisma) sein, aus denen sich eine CAD-Struktur zusammensetzen kann. Generell kann ein CAD-Bauteil eine Anzahl, insbesondere eine Mehrzahl, von Punkten im Raum sein.

Eine Beschriftung (z.B. Buchstaben, Zahlen, Symbole) oder Bemaßung in einem CAD-Programm ist dagegen weder ein CAD-Bauteil noch eine CAD-Struktur, da eine Beschriftung oder Bemaßung nicht zur "Substanz" einer CAD-Struktur gehört, sondern nur eine Information zu einer besonderen Eigenschaft der CAD-Struktur darstellt.

Ein CAD-Bauteil lässt sich demnach als ein Objekt in einem CAD-Programm beschreiben, das mit einer Bemaßung oder Beschriftung gemäß einer herkömmlichen Funktionalität eines CAD-Programms versehen werden kann.

Auch das erfindungsgemäße Bauteilelement ist im Grunde eine CAD-Struktur im 3D-Raum, da es ebenfalls aus CAD-Bauteilen zusammengesetzt ist. Es wird jedoch, um Missverständnisse auszuschließen, der Begriff CAD-Struktur im Folgenden einschränkend nur für dasjenige Objekt verwendet, welches ein Benutzer im CAD-Programm erstellt hat und dem er Informationen hinzufügen möchte. Dafür kann er die erfindungsgemäßen Bauteilelemente verwenden. Die Bauteilelemente dienen also demgegenüber als reine Informationsträger, da deren Form Informationen vermitteln soll. Es sind regelmäßig Informationen über das Objekt, es bleibt aber letztendlich einem Benutzer überlassen, welche Information er darstellen möchte.

Die Erfindung bezieht sich auf 3D-CAD-Programme und dort auf Bauteilelemente in einem 3D-Raum. Dies schließt zweidimensional Bauteilelemente nicht aus, bevorzugt sind die Bauteilelemente aber dreidimensional.

Ein erfindungsgemäßes Bauteilelement umfasst wiederum mindestens einen Ankerpunkt und zumindest ein Informationselement. Das Informationselement dient dabei als Träger einer Information, die das Bauteilelement verkörpert, und der Ankerpunkt zur Zuordnung der Information zu einer Stelle, zu einem Punkt bzw. geometrischen Ort einer CAD-Struktur. Der Ankerpunkt greift dazu im Grunde an einem CAD-Bauelement der CAD-Struktur an. Die Position des Informationselements - und damit ist insbesondere auch seine Orientierung, also seine Ausrichtung im Raum - ist dabei relativ zu zumindest einem der Ankerpunkte einstellbar festgelegt. Dies ist z.B. auch bei einer herkömmlichen Bemaßung nicht anders, weil die Maßzahl der Bemaßung relativ zu den angewählten Punkten angezeigt wird.

Das erfindungsgemäße Bauteilelement unterscheidet sich jedoch von einer herkömmlichen Bemaßung bzw. Bezeichnung. Zwar ist auch jene im Objektraum sichtbar, ohne jedoch Teil des Objektraumes zu sein. Das erfindungsgemäße Bauteilelement ist dagegen zugleich auch Teil des Objektraumes. Das Bauteilelement stellt somit ein spezielles Bemaßungselement dar, welches im Grunde nichts mit dem Objekt gemeinsam hat, außer dass es ein Maß des Objektes darstellt und angezeigt wird. Eine "normale" bzw. herkömmliche Bemaßung ist also per se kein Element, welches mit einer CAD-Struktur vergleichbar ist. Das erfindungsgemäße Bauteilelement aus Informationselement(en) und Ankerpunkt(en) hingegen ist selbst eine eigene CAD-Struktur.

Somit stellt die Art des erfindungsgemäßen Bauteilelements einen wesentlichen Unterschied zum Stand der Technik dar. Es wird nämlich aus einer Anzahl von geometrischen CAD-Bauteilen gebildet. Es ist also ein Objekt, welches im 3D-Raum eines CAD-Programms angeordnet, d.h. nicht nur dargestellt, sondern positioniert ist und als Gruppe von CAD-Bauteilen verarbeitet werden kann.

Das Informationselement umfasst bevorzugt Linien (wie z.B. gerade Linien, Spirale, Helix oder Spline), Flächen und/oder Körper (wie z.B. Quader, Zylinder, Kegel, Ellipsoid, Kugel, Torus, Pyramide oder Prisma), welche die Form von Zeichen haben, so dass es aufgrund seiner Form(en) eine Information vermittelt, z.B. Zahlen für eine Bemaßung.

Das erfindungsgemäße Bauteilelement ist dabei dazu ausgelegt, mit CAD-Bauteilen einer CAD-Struktur verknüpft zu werden, so dass es zusammen mit den CAD-Bauteilen (ggf. mit der gesamten CAD-Struktur) bewegt werden kann, bzw. bewegt wird, wenn entsprechende CAD-Bauteile bewegt werden, mit denen das Bauteilelement verknüpft ist. Dazu wird eine Anzahl von Ankerpunkten des CAD-Bauteils mit Punkten (z.B. Eckpunkten oder Punkten auf Flächen oder Kanten) anderer CAD-Bauteile verankert. Dies geschieht derart, dass Änderungen der Position eines der Punkte mit einer entsprechenden Änderung der Position des mit diesem Punkt gekoppelten Ankerpunktes einhergehen. Da das Informationselement bezüglich seiner Position relativ zu den Ankerpunkten festgelegt ist, bewegt sich das Informationselement und damit das erfindungsgemäße Bauteilelement mit "seinen" Ankerpunkten mit. Die relative Position des Bauteilelements ist dabei einstellbar festgelegt, was bedeutet, dass sie zwar durch Einstellung (nach einer Eingabe eines Benutzers) verändert werden kann, danach aber wieder festgelegt ist.

Beispielsweise kann ein Bauteilelement einen Ankerpunkt und ein Informationselement in Form eines Symbols und eines Pfeils umfassen. Die Spitze des Pfeils kann der Ankerpunkt sein. Ein beispielhaftes anderes Bauteilelement kann zwei Ankerpunkte aufweisen, zwischen denen ein Informationselement in der Form einer Bemaßungslinie und Elemente in der Form von Zahlen, die eine Bemaßung darstellen, ausgestaltet ist.

Eine erfindungsgemäße CAD-Struktur umfasst mindestens ein Bauteilelement gemäß der Erfindung, wobei mindestens ein Ankerpunkt des Bauteilelements an einem Punkt eines CAD-Bauteils einer CAD-Struktur verankert ist.

Ein erfindungsgemäßes Verfahren dient zur Erstellung einer CAD-Struktur gemäß der Erfindung. Es umfasst die folgenden Schritte:
- Erstellen einer CAD-Struktur mittels eines CAD-Programms aus CAD-Bauteilen,
- Auswählen eines Bauteilelements gemäß der Erfindung,
- Verankern mindestens eines Ankerpunktes des ausgewählten Bauteilelements mit einem Punkt der CAD-Struktur.

Das Erstellen einer CAD-Struktur ist im Stand der Technik hinreichend bekannt. Die CAD-Bauteile zum Erstellen der CAD-Struktur können von einem CAD-Programm standardmäßig vorgegebene oder benutzerdefinierte Basisbauteile sein.

Nach der Auswahl eines Bauteilelements können dessen Ankerpunkte mittels eines Zeigegerätes und Anwahl eines Punktes der CAD-Struktur mit dem Punkt der CAD-Struktur verknüpft werden.

Die Erfindung kann insbesondere in Form einer Rechnereinheit mit geeigneter Software realisiert sein. Die Rechnereinheit kann hierzu z.B. einen oder mehrere zusammenarbeitende Mikroprozessoren oder dergleichen aufweisen. Insbesondere kann sie in Form von geeigneten Softwareprogrammteilen in der Rechnereinheit realisiert sein. Eine weitgehend software-mäßige Realisierung hat den Vorteil, dass auch schon bisher verwendete Rechnereinheiten auf einfache Weise durch ein Software- bzw. Firmware-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in eine Speichereinrichtung einer Rechnereinheit ladbar ist, mit Programmabschnitten, um alle Schritte des erfindungsgemäßen Verfahrens auszuführen, wenn das Programm in der Rechnereinheit ausgeführt wird. Ein solches Computerprogrammprodukt kann neben dem Computerprogramm gegebenenfalls zusätzliche Bestandteile wie z.B. eine Dokumentation und/oder zusätzliche Komponenten, auch Hardware-Komponenten, wie z.B. Hardware-Schlüssel (Dongles etc.) zur Nutzung der Software, umfassen.

Zum Transport zur Rechnereinheit und/oder zur Speicherung an oder in der Rechnereinheit kann ein computerlesbares Medium, beispielsweise ein Memorystick, eine Festplatte oder ein sonstiger transportabler oder fest eingebauter Datenträger dienen, auf welchem die von einer Rechnereinheit einlesbaren und ausführbaren Programmabschnitte des Computerprogramms gespeichert sind.

Weitere, besonders vorteilhafte Ausgestaltungen und Weiterbildungen der Erfindung ergeben sich aus den abhängigen Ansprüchen sowie der nachfolgenden Beschreibung, wobei die Ansprüche einer Anspruchskategorie auch analog zu den Ansprüchen und Beschreibungsteilen zu einer anderen Anspruchskategorie weitergebildet sein können und insbesondere auch einzelne Merkmale verschiedener Ausführungsbeispiele bzw. Varianten zu neuen Ausführungsbeispielen bzw. Varianten kombiniert werden können.

Bevorzugt umfasst das Bauteilelement zumindest ein CAD-Bauteil, welches ein Basisobjekt des CAD-Programms ist, das vom CAD-Programm zur Erstellung von CAD-Strukturen bereitgestellt wird. Bevorzugt umfasst das Bauteilelement dazu eine Anzahl von CAD-Bauteilen ausgewählt aus der Gruppe Quader, Zylinder, Kugel, Keil, Kegel, Torus, Fläche, Linie, Spirale, Helix und Spline. Das CAD-Bauteil ist dabei bevorzugt dreidimensional, was die Sichtbarkeit aus allen möglichen Blickwinkeln verbessert.

Bevorzugt umfasst ein Informationselement des Bauteilelements ein Symbolelement, welches aus einer Anzahl von CAD-Bauteilen gebildet ist, insbesondere in Form einer Ziffer, eines Symbols, eines Logos oder eines Schriftzeichens. Das erfindungsgemäße Symbolelement ist aber kein abstraktes Zeichen, z.B. ein Buchstabe oder eine Ziffer, sondern ein aus CAD-Bauteilen zusammengestelltes CAD-Objekt in Form des Zeichens, z.B. eine dreidimensionale Struktur in Form einer Ziffer oder eines Buchstabens.

Das Informationselement umfasst dabei bevorzugt eine Mehrzahl von Symbolelementen in Form einer Zeichenkette. Beispielsweise stellt das Symbolelement eine dreidimensionale Struktur in Form eines Wortes dar oder eines Maßes wie z.B. Lettern in Form der Zeichenkette "1640 mm", vergleichbar dem bekannten "Hollywood"-Schriftzug: Er ist im Grunde nicht das Wort, sondern eine Anordnung von dreidimensionalen Objekten, die in ihrer Anordnung als das Wort "Hollywood" gelesen werden.

Ein bevorzugtes Bauteilelement zeichnet sich dadurch aus, dass das Informationselement ein verbindendes Bezugselement in Form einer Anzahl von geometrischen CAD-Bauteilen zwischen einem Symbolelement mindestens einem Ankerpunkt (z.B. zumindest zwei Ankerpunkten für eine Bemaßung oder einem Ankerpunkt für eine Beschriftung) und aufweist. Das Bezugselement setzt eine Anzahl von Ankerpunkten mit dem Symbolelement optisch miteinander in Beziehung. Es kann z.B. eine Bemaßungslinie zwischen zwei Ankerpunkten sein oder ein Pfeil oder ein Strich zu einem oder mehreren Ankerpunkt(en), der andeutet, dass das Symbolelement den betreffenden Ort des Ankerpunkts bzw. der Ankerpunkte bezeichnen soll. Das Bezugselement reicht dabei vorzugsweise im Wesentlichen von einem Ankerpunkt zu dem anderen Ankerpunkt oder zu dem Symbolelement. Es kann aber auch einen vorgegebenen und ggf. einstellbaren Abstand zum Ankerpunkt haben. Das Bezugselement ist bevorzugt eine Linie oder eine linienförmige Fläche oder ein linienförmiges Volumen. Mit "linienförmig" ist gemeint, dass die Ausdehnung in einer Raumrichtung bedeutend länger ist als die Ausdehnung in den übrigen Raumrichtungen, bevorzugt mindestens zehn Mal länger.

Bevorzugt weist das Informationselement ein Funktionselement auf, das eine Anzahl von vorgegebenen Parametern des CAD-Programms abfragt und eine Anzahl von Symbolelementen und/oder Bezugselementen abhängig von den abgefragten Werten der vorgegebenen Parameter positioniert. Hierzu sei angemerkt, dass ein Bauteilelement ein Objekt (ein funktionales Element) in einem CAD-Programm ist. Das CAD-Programm kann dabei auch Funktionalitäten erlauben, z.B. dass bei einem Bauteilelement mit einer Bemaßungsfunktion (einem "Bemaßungs-Bauteilelement") automatisch ein Abstand zwischen zwei Ankerpunkten berechnet wird. Diese Funktionalität ist dabei fest mit dem Bauteilelement verknüpft. Wenn also z.B. ein solches Bemaßungs-Bauteilelement zur Bemaßung einer CAD-Struktur ausgewählt wurde und deren Ankerpunkte mit Punkten der CAD-Struktur verknüpft worden sind, berechnet das Funktionselement automatisch den Abstand der Ankerpunkte (ggf. nur bezüglich einer vorgegebenen Raumachse) und der berechnete Wert wird in Form von Symbolelementen ausgegeben, die das entsprechende Maß repräsentieren.

Das Funktionselement ist bevorzugt dazu ausgelegt, eine Streckenlänge zwischen zwei Ankerpunkten zu ermitteln und Symbolelemente als Zeichenkette entsprechend des ermittelten Wertes der Streckenlänge darzustellen und/oder Bezugselemente entsprechend einer Distanz zwischen den Ankerpunkten darzustellen, z.B. eine Maßlinie mit Maßzahl.

Alternativ oder zusätzlich ist das Funktionselement bevorzugt dazu ausgelegt, eine Position eines Ankerpunktes relativ zu einem Bezugsort zu ermitteln und Symbolelemente als Zeichenkette entsprechend der ermittelten Position darzustellen und/oder Bezugselemente in Form eines auf die ermittelte Position deutenden Elements oder einer Höhenkote darzustellen.

Alternativ oder zusätzlich ist das Funktionselement bevorzugt dazu ausgelegt, einen gewählten Maßstab oder einen gewählten Betrachtungsabstand zur CAD-Struktur zu ermitteln, die Größe von Symbolelementen und/oder Bezugselementen in Abhängigkeit von dem ermittelten Wert festzulegen und die Symbol- und/oder Bezugselemente entsprechend darzustellen. Bevorzugt ist das Funktionselement auch dazu ausgelegt ein Bauteilelement basierend auf dem ermittelten Maßstab oder Betrachtungsabstand automatisch zu skalieren.

Alternativ oder zusätzlich ist das Funktionselement bevorzugt dazu ausgelegt, eine von einem CAD-Bauteil unabhängige Information darzustellen, z.B. eine "fachlich übergreifende inhaltliche Information" wie z.B. Symbolelemente repräsentierend den Schriftzug: "Solch eine Struktur ist gesetzlich vorgeschrieben".

Ein bevorzugtes Bauteilelement umfasst eine Funktion, welche einen ermittelten Wert in eine Anzahl von einzelnen Zeichen zerlegt und für jedes Zeichen ein Symbolelement auswählt. Diese Funktion unterscheidet sich von der Funktion des Funktionselements dadurch, dass nicht automatisiert Informationen ermittelt werden, sondern Symbolelemente gezielt ausgewählt werden:
Im Unterschied zu abstrakten Zeichen, die einfach zu Zeichenketten angeordnet werden können, sind die Symbolelemente als selbständige Objekte eines CAD-Programms vorhanden. Dazu können sie z.B. aus einem Speicherbereich heruntergeladen und einem Bauteilelement hinzugefügt werden. Sie können aber auch bereits (unsichtbar) im Bauteilelement vorliegen. Beispielsweise können Symbolelemente, die die Ziffern 0 bis 9 repräsentieren, an derselben Position oder als Stapel übereinander vorliegen. Soll an der Stelle eine bestimmte Ziffer angezeigt werden, kann das entsprechende Symbolelement von unsichtbar auf sichtbar geschaltet werden. Alternativ kann der Stapel von Symbolelementen entsprechend eines relativen Wertes zwischen 0 und 9 auf ein Volumen-element (ein dreidimensionales CAD-Bauteil) in der Größe der Symbolelemente verschoben werden, mit dem der Stapel mit einem logischen "UND" verknüpft ist und damit die Schnittmenge angezeigt wird. Es wird somit nur ein Symbolelement, welches in das Volumenelement verschoben wurde, sichtbar, und die Symbolelemente können entsprechend ihrer dargestellten Ziffer verschoben werden. Beispielsweise liegt das Symbolelement "0" im Volumenelement und das Symbolelement "9" wird erst sichtbar, wenn der Stapel um 9 Schritte verschoben worden ist.

Generell wird dasjenige Symbolelement ausgewählt, dessen Darstellung dem Zeichen entspricht, welches dargestellt werden soll, z.B. eine bestimmte Ziffer für einen Zahlenwert oder ein bestimmter Buchstabe. Jedem Typ der Zeichen wird bevorzugt ein individueller Zeichen-wert zugewiesen, z.B. dessen ASCII-Wert oder ein dazu relativer Wert. Die Auswahl eines Symbolelements basiert dann auf dem Zeichenwert. Auf diese Weise lassen sich auch Buchstaben gemäß einem numerischen Wert dem entsprechenden Symbolelement zuordnen.

Es ist dabei bevorzugt, dass das Bauteilelement eine Funktion umfasst, die ein Symbolelement gemäß einem Zeichen, insbesondere dessen Zeichenwerts, aus einer Liste auswählt. Diese Liste ist bevorzugt eine Liste von vorgefertigten Symbolelementen oder eine Liste von Dateien von abgespeicherten Symbolelementen.

Alternativ oder zusätzlich ist bevorzugt, dass das Bauteilelement eine Funktion umfasst, die ein Symbolelement, das im CAD-Raum zunächst unsichtbar ist, auswählt und sichtbar macht. Dies geschieht bevorzugt dadurch, dass ein an der entsprechenden Stelle platziertes Symbolelement durch Setzen einer Information als sichtbar deklariert wird oder indem ein Symbolelement an eine vorgegebene Stelle verschoben wird und dort sichtbar gemacht wird, bevorzugt durch Bilden einer Schnittmenge mit einem vorher dort platzierten Körper (s. vorangehende Erläuterungen).

Alternativ oder zusätzlich ist bevorzugt, dass das Bauteilelement eine Funktion umfasst, die ein Symbolelement in den CAD-Raum an eine vorgegebene Stelle kopiert. Es kann dabei eine Menge an Symbolelementen unsichtbar vorliegen, z.B. die Buchstaben des Alphabets sowie Ziffern, und es wird eine Anzahl von sichtbaren Kopien des jeweils betreffenden Symbolelements an bestimmte Stellen im Raum positioniert, um ein Informationselement, z.B. einen Schriftzug oder eine Maßangabe zu bilden.

Ein bevorzugtes Bauteilelement zeichnet sich dadurch aus, dass eine Mehrzahl von Symbolelementen unterschiedlicher Typen von Zeichen, bevorzugt die Ziffern von 0 bis 9 oder die Schriftzeichen eines Alphabets, z.B. Buchstaben, als Block relativ zu einem gemeinsamen Ankerpunkt angeordnet sind, insbesondere an derselben Position. Sie sind zunächst im Raum unsichtbar oder visuell nicht aktiviert. Bei Auswahl eines Zeichens wird dann das Zeichen im Raum dargestellt, bevorzugt an seiner Position. Alternativ kann die Anzeige auch dadurch erfolgen, dass die Information des Symbolelements an einer anderen Position übernommen wird, z.B. mittels eines sog. "Pointers". Denn manche CAD-Programme erlauben es, CAD-Bauteile oder Gruppen von CAD-Bauteilen als eine zusätzliche CAD-Struktur mittel Verweis (Pointer) zu übernehmen. Die interne Struktur der Objekte ist dabei identisch - es wird lediglich auf das ursprüngliche Objekt verwiesen. Die unterschiedlichen Objekte können aber an unterschiedlichen Positionen im Raum angeordnet werden. Es ist also möglich, ein Symbolelement nur einmal zu erstellen und mittels Verweis auf das Symbolelement mehrere identische Symbolelemente an unterschiedlichen Positionen im Raum anzuordnen.

Eine erfindungsgemäß bevorzugte CAD-Struktur zeichnet sich dadurch aus, dass das Informationselement des Bauteilelements eine Eigenschaft des CAD-Bauteils repräsentiert, und bevorzugt eine Bezeichnung für das CAD-Bauteil angibt oder eine Bemaßung für das CAD-Bauteil angibt. Damit lässt sich eine CAD-Struktur dynamisch bemaßen oder beschriften.

Gemäß einer bevorzugten Ausführungsform des Verfahrens wird nach dem Verankern die CAD-Struktur manipuliert, insbesondere bewegt oder verformt, bevorzugt extrudiert. Erfindungsgemäß verändert dabei jeder Ankerpunkt des Bauteilelements, der mit einem Punkt des Bauteilelements verankert ist, seine Position zusammen mit dem betreffenden Punkt der CAD-Struktur. Beispielsweise wird eine CAD-Struktur gestreckt, indem ihre Länge in nur einer Raumrichtung verändert wird. Erfindungsgemäß ändert sich dann eine Bemaßung entsprechend dem Abstand zweier Ankerpunkte automatisch, wenn sich deren Abstand ändert. Außerdem wird automatisch das Informationselement an den veränderten Wert angepasst. Dies geschieht dadurch, dass die entsprechenden Symbolelemente am Ende des Vorgangs sichtbar sind. Es können dabei die Symbolelemente gewechselt werden oder andere Symbolelemente sichtbar gemacht werden.

Bevorzugt umfasst das Verfahren die Schritte:
- Bereitstellen einer Vielzahl von Symbolelementen in Form von Zeichen in einer Liste oder einem Raum,
- Abfragen einer Anzahl von vorgegebenen Parametern des CAD-Programms und Erhalten einer Anzahl von Parameterwerten in Form von Zeichenketten,

Für jeden Parameterwert der Anzahl von Parameterwerten
- Zerlegen der Zeichenkette des Parameterwerts in einzelne Zeichen,
- Auswahl von Symbolelementen, die den Zeichen entsprechen,
- Anordnen der Symbolelemente in Form einer Zeichenkette, die der Zeichenkette des Parameterwerts entspricht, so dass die Symbolelemente sichtbar im Informationselement des Bauteilelements vorliegen.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Die Figuren sind in der Regel nicht maßstäblich. Es zeigen:
Figur 1 eine CAD-Struktur mit zwei Bauteilelementen gemäß der Erfindung,
Figur 2 eine CAD-Struktur mit mehreren Bauteilelementen gemäß der Erfindung,
Figur 3 die CAD-Struktur von Figur 2 in einer perspektivischen Ansicht,
Figur 4 die CAD-Struktur von Figur 2 in abgewandelter Form,
Figur 5 die CAD-Struktur von Figur 4 in einer perspektivischen Ansicht,
Figur 6 eine Möglichkeit der Auswahl eines Symbolelements eines Bauteilelements,
Figur 7 ein Bauteilelement mit einem Funktionselement,
Figur 8 die Anordnung eines Bauteilelements an einer CAD-Struktur.

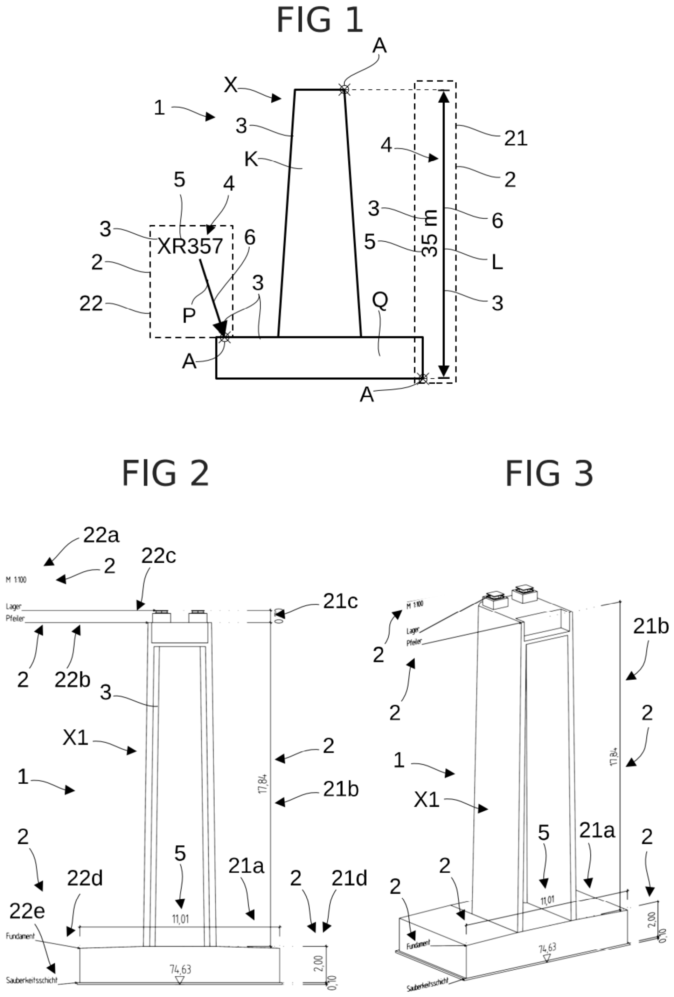

Figur 1 zeigt eine beispielhafte CAD-Struktur 1, nämlich einen vereinfacht dargestellten Pylonen X für eine Brücke in einer Seitenansicht. Der Pylon X ist aus zwei CAD-Bauteilen 3, nämlich aus einem liegenden Quader Q als Basis und aus einem darauf angeordneten Keil K, erstellt worden.

Die CAD-Struktur 1 umfasst außerdem zwei Bauteilelemente 2 gemäß der Erfindung, nämlich ein Bemaßungs-Bauteilelement 21 und ein Bezeichnungs-Bauteilelement 22. Auch die Bauteilelemente 2 sind aus CAD-Bauteilen 3 ausgebildet.

Bei dem Bezeichnungs-Bauteilelement 22 ist der Schriftzug "XR357" in Form eines entsprechenden Symbolelements 5 als Informationselement 4 für den Quader Q gebildet. Ein Bezugselement 6 in Form eines Pfeils P verdeutlicht, dass der Quader Q mit dem Informations-element 4, nämlich mit dessen Schriftzug "XR357", bezeichnet ist. Die Spitze des Pfeils P bildet einen Ankerpunkt A, der mit einem entsprechenden Punkt des Quaders Q verknüpft ist.

Mit dem Bemaßungs-Bauteilelement 21 wird die Höhe des Pylons X der CAD-Struktur 1 bemaßt. Das Informationselement 4 des Bemaßungs-Bauteilelements 21 setzt sich aus den Symbolelementen 5, die zusammen den Schriftzug "35 m" ergeben, und dem Bezugselement 6, einer Bemaßungslinie L, zusammen. Die Enden der Bemaßungslinie L sind mittels Ankerpunkten A mit der Unterkante des Quaders Q und der Oberkante des Keils K verbunden.

Die sichtbaren Bauteilelemente 2 sind aus CAD-Bauteilen zusammengesetzt. Beispielsweise kann die Ziffer "Eins" aus zwei Zylindern zusammengesetzt sein, welche wie die Ziffer 1 angeordnet sind, und ein Pfeil P aus einer Linie oder einem langen, dünnen Zylinder mit einem Kegel als Spitze. Der Pfeil P und die Bemaßungslinie L können aus Linien bzw. Flächen (z.B. ein Dreieck für die Pfeilspitze) zusammengesetzt sein, sind aber in diesem Beispiel aus dünnen dreidimensionalen Körpern zusammengesetzt, damit sie besser sichtbar sind.

Figur 2 zeigt eine CAD-Struktur 1 mit mehreren Bauteilelementen 2 gemäß der Erfindung. Sie zeigt eine Schnittansicht eines Pylonen X1. Es sind mehrere Bezeichnungs-Bauteilelemente 22a, 22b, 22c, 22d und Bemaßungs-Bauteilelemente 21a, 21b, 21c, 21d darstellt, die entsprechend Figur 1 mit (hier nicht dargestellten) Ankerpunkten A mit Punkten der CAD-Struktur 1 verknüpft sind. Die Bemaßungs-Bauteilelemente 21a und 21d geben Abmessungen eines Fundaments und seiner Sauberkeitsschicht, das Bemaßungs-Bauteilelement 21b die Höhe eines Pfeilers und das Bemaßungs-Bauteilelement 21c die Höhe eines Lagers des Pylons X1 an. Die Bezeichnungs-Bauteilelemente 22a, 22b, 22c, 22d, 22e geben die Funktionen zum Beispiel des dem Quader Q aus Figur 1 entsprechenden Bauteils als "Lager" und des dem Keils K gemäß Figur 1 entsprechenden Bauteils des Pylons X1 als "Pfeiler" an.

Figur 3 zeigt die CAD-Struktur von Figur 2 in einer perspektivischen Ansicht. Hier ist zu erkennen, dass sich nicht nur die Perspektive der CAD-Struktur 1 im Vergleich zu Figur 2 geändert wurde, sondern auch entsprechend die Perspektive der Bauteilelemente 2. Dies ist auch kein Wunder, da die Bauteilelemente 2 ebenfalls Objekte im CAD-Raum sind und im Grunde zur CAD-Struktur 1 gehören.

Um ausgehend von der Ansicht der Figur 2 zu derjenigen der Figur 3 zu gelangen, lässt sich der Ansichtsmodus der CAD-Struktur 1, also des Pylons X1 und der Bauteilelemente 2 der Figur 2, von einer Frontansicht in eine perspektivische Ansicht wechseln. Alternativ kann die CAD-Struktur 1 im Raum gedreht werden. Da die Bauteilelemente 2 auch CAD-Strukturen sind, drehen sie sich im Raum mit bzw. wird ihre Ansicht entsprechend der Ansicht der CAD-Struktur 1 geändert. Entsprechend der Änderung der Perspektive von einer Frontansicht des Pylons X1 der Figur 2 zu einer perspektivischen Ansicht des Py-Ions X1 der Figur 3 ändert sich auch die Perspektive der Bauteilelemente 2 von einer Fronansicht in der Figur 2 zu einer perspektivischen Ansicht in der Figur 3.

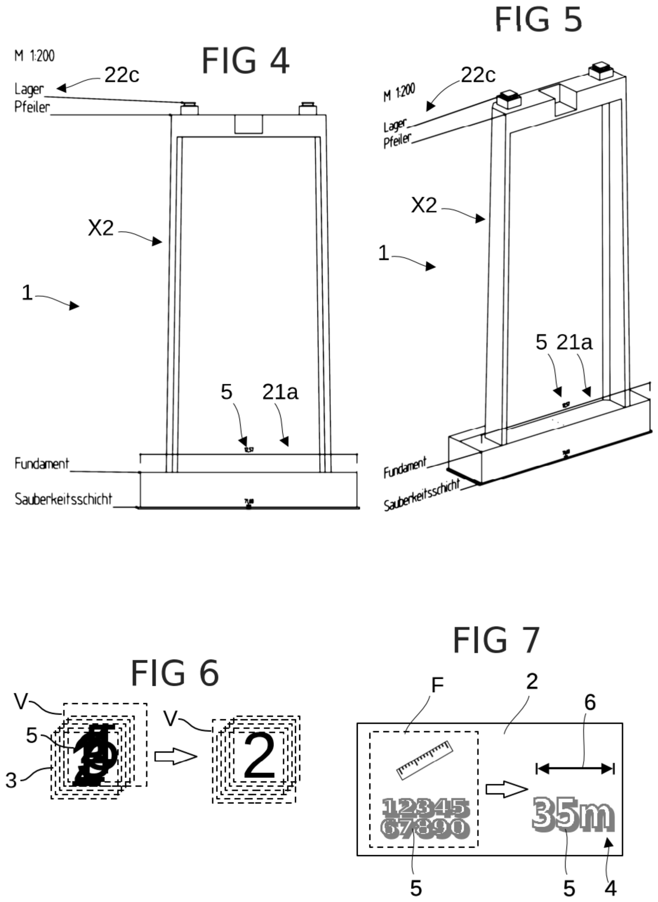

Figur 4 zeigt einen Pylon X2. Er wurde durch Manipulation ausgehend von der CAD-Struktur 1 der Figuren 2, 3 erhalten. Im Vergleich zu Figur 2 wurde der Pylon X2 u.a. vertikal und in der Zeichnungsebene der Figur 2 gestreckt und orthogonal zur Zeichnungsebene gestaucht.

Trotz der Änderungen des Pylons X2 gegenüber dem Pylon X1 sind die Bauteilelemente 2 des CAD-Objekts 1 der Figuren 4, 5 noch weiterhin mit ihren (nicht dargestellten) Ankerpunkten A und damit mit den entsprechenden Punkten der CAD-Struktur 1 verknüpft. Auch die Maße und damit die Symbolelemente 5 der Bemaßungs-Bauelemente 21a haben sich automatisch angepasst.

Figur 5 zeigt die CAD-Struktur 1 von Figur 4 in einer perspektivischen Ansicht. Auch hier werden die Bauteilelemente 2 wie in Figur 3 entsprechend perspektivisch dargestellt.

Figur 6 zeigt eine Möglichkeit der Auswahl eines Symbolelements 5 als CAD-Bauteil 3 eines Bauteilelements 2. Im virtuellen CAD-Raum sind links mehrere Symbolelemente 5 in Form eines Stapels räumlich übereinander angeordnet. Jedes Symbolelements 5 hat daher eine individuelle Lage im Raum. Zur Verdeutlichung sind zwar alle Symbolelemente 5 sichtbar, in der Praxis jedoch sind die Symbolelemente 5 unsichtbar. In dem hier gezeigten Beispiel sind die Symbolelemente 5 alle mittels einer logischen "UND"-Verknüpfung mit einem Volumen-element V, das die Form eines Würfels hat, verknüpft. Die Symbolelemente 5 liegen alle räumlich über dem Volumenelement V. Es wird also die Schnittmenge aus dem Volumen-element V und aus den Symbolelementen 5 dargestellt. Daher ist links tatsächlich kein Symbolelement 5 sichtbar, weil keines an der Position des Volumenelements V liegt. Dazu wird davon ausgegangen, dass das betreffende CAD-Programm Verknüpfungen von Objekte automatisch als sichtbare Objekte darstellt. Zunächst ist ein unverknüpftes Objekt nicht sichtbar, da keine Schnittmenge existiert. Wenn die UND-Verknüpfung eine Überlappung mit einem anderen Objekt anzeigt, es also eine Schnittmenge gibt, ist das Objekt bzw. die Schnittmenge sichtbar.

Analog zu dem beispielhaft beschriebenen Vorgehen einer logischen "UND"-Verknüpfung können weitere booleschen Operationen wie z.B. eine "Subtraktion/Abzug"-Verknüpfung verwendet werden, um die gewünschte Sichtbarkeit des Symbolelementes zu erzeugen. Die Symbolelemente 5 liegen alle räumlich in einem Volumenelement V, das die Form eines Würfels hat. Es werden alle Symbolelemente 5 durch eine Subtraktions-Verknüpfung mit diesem Volumenelement V verknüpft, wodurch alle Symbolelemente 5 nicht sichtbar sind. Ein Symbolelement 5 wird sichtbar, wenn es sich durch Positionsänderung außerhalb des Volumenelementes V befindet. Das Volumenelement V ist selbst nicht sichtbar.

Rechts in Figur 6 wurde nun das Symbolelement 5, welches die Form der Ziffer "2" hat, auf das Volumenelement V verschoben. Das Symbolelement 5 der Ziffer "2" ist nun sichtbar, weil die "UND"-Verknüpfung des Symbolelements 5 der Ziffer "2" mit dem Volumen-element V als Schnittmenge die Darstellung der Ziffer "2" ergibt, während die Symbolelemente 5 aller anderen Ziffern weiterhin unsichtbar bleiben.

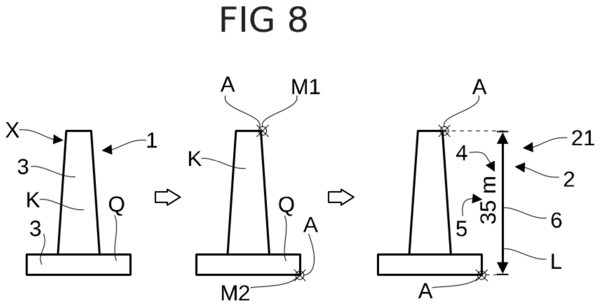

Figur 7 zeigt ein Bauteilelement 2 mit einem Funktionselement F, welches für eine Bemaßung verwendet werden kann. Das Funktionselement F misst den Abstand zweier Ankerpunkte A des Bauteilelements 2, z.B. die Maßpunkte M1, M2 der nachfolgenden Figur 8, und ordnet dem gemessenen Wert eine Anzahl von Symbolelementen 5 zu, die dann zu einer Repräsentation einer Bemaßung angeordnet werden, in Figur 7 rechts dargestellt. Die Länge einer Bemaßungslinie als Bezugselement 6 sowie Anordnung und Auswahl der Symbolelemente 5 nimmt die Funktionseinheit F selbst vor.

Figur 8 zeigt die Anordnung eines Bauteilelements 2 an einer CAD-Struktur 1 wie sie in Figur 1 dargestellt ist. Zunächst (links) wird die CAD-Struktur 1 aus einem Keil K und einem Quader Q (beides CAD-Bauteile 3) erstellt. Dann (Mitte) werden individuellen Punkte der CAD-Struktur entsprechende Ankerpunkten A zugewiesen. Sie sollen einer Bemaßung dienen. Daher sind die Ankerpunkte A die Maßpunkte M1, M2. Einem oberen Punkt des Keils K wird einem ersten Maßpunkt M1 als ersten Ankerpunkt A zugewiesen und ein unterer Punkt des Quaders Q einem zweiten Maßpunkt M2 als zweiten Ankerpunkt A zugewiesen. Zwischen den beiden Maßpunkten M1, M2 wird anschließend (rechts) automatisch eine aus mehreren CAD-Bauteilen 3 zusammengesetzte Bemaßungslinie L als Bezugselement 6 und ein aus mehreren CAD-Bauteilen 3 zusammengesetzter Schriftzug "35 m" als Symbolelement 5 hinzugefügt. Dies kann so erfolgen wie in Figur 7 beschrieben, dass ein Funktionselement F den Abstand der zwei Maßpunkte M1, M2 misst und dem gemessenen Wert eine Anzahl von Symbolelementen 5 zugeordnet wird. Die Länge 35 m wird z.B. auf diese Weise automatisch aus der Distanz der Maßpunkte M1, M2 zueinander errechnet. Das Symbolelement 5 und das Bezugselement 6 bilden zusammen ein Informationselement 4 und die gesamte Gruppe aus CAD-Bauteilen 3 bildet das Bauteilelement 2, welches ein Bemaßungs-Bauteilelement 21 ist.

Ein Bezeichnungs-Bauteilelement 22 kann entsprechend erstellt werden, wobei hierzu regelmäßig nur ein einziger Ankerpunkt A notwendig ist. Die Ausrichtung eines Bezugselements 6 und eines Symbolelements 5 kann dabei durch einen Benutzer festgelegt werden oder sie wird automatisch festgelegt.

Es wird abschließend noch einmal darauf hingewiesen, dass es sich bei der vorhergehend detailliert beschriebenen Erfindung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließen Begriffe wie "Einheit" nicht aus, dass die betreffenden Komponenten aus mehreren zusammenwirkenden Teil-Komponenten bestehen, die ggf. auch räumlich verteilt sein können. Der Begriff "eine Anzahl" ist als "mindestens ein(e)" zu lesen.

### Bezugszeichenliste

- 1: CAD-Struktur
- 2: Bauteilelement
- 21, 21a ... 21d: Bemaßungs-Bauteilelement
- 22, 22a ...22d: Bezeichnungs-Bauteilelement
- 3: CAD-Bauteil
- 4: Informationselement
- 5: Symbolelement
- 6: Bezugselement
- A: Ankerpunkt
- F: Funktionselement
- K: Keil
- L: Bemaßungslinie
- M1, M2: Maßpunkt
- P: Pfeil
- Q: Quader
- V: Volumenelement
- X, X1, X2: Pylon

## Patentansprüche

1. Bauteilelement (2) eines 3D CAD-Programms umfassend eine Anzahl von Ankerpunkten (A) und zumindest ein Informationselement (4) in Form einer Anzahl von geometrischen CAD-Bauteilen (3), dessen Position relativ zu zumindest einem der Ankerpunkte (A) einstellbar festgelegt ist, wobei das Bauteilelement (2) funktionell dazu ausgelegt ist, mit seiner Anzahl von Ankerpunkten (A) mit Punkten anderer CAD-Bauteile (3) derart verankert zu werden, dass Änderungen der Position eines der Punkte der CAD-Bauteile mit einer entsprechenden Änderung der Position des mit diesem Punkt gekoppelten Ankerpunktes (A) einhergeht.

2. Bauteilelement (2) nach Anspruch 1, umfassend zumindest ein CAD-Bauteil (3), welches ein Basisobjekt des CAD-Programms ist, das vom CAD-Programm zur Erstellung von CAD-Strukturen (1) bereitgestellt wird, wobei das CAD-Bauteil (3) bevorzugt dreidimensional ist.

3. Bauteilelement (2) nach einem der vorangehenden Ansprüche, wobei ein Informationselement (4) ein Symbolelement (5) umfasst, welches aus einer Anzahl von CAD-Bauteilen (3) gebildet ist, insbesondere in Form einer Ziffer, eines Symbols, eines Logos oder eines Schriftzeichens, wobei das Informationselement (4) bevorzugt eine Mehrzahl von Symbolelementen (5) in Form einer Zeichenkette umfasst.

4. Bauteilelement (2) nach einem der vorangehenden Ansprüche, wobei das Informationselement (4) ein verbindendes Bezugselement (6) in Form einer Anzahl von geometrischen CAD-Bauteilen (3)
- zwischen zumindest zwei Ankerpunkten (A) oder
- zwischen einem Ankerpunkt (A) und einem Symbolelement (5) aufweist, welches eine Anzahl von Ankerpunkten (A) mit dem Symbolelement (5) optisch miteinander in Beziehung setzt,
wobei das Bezugselement (6) vorzugsweise im Wesentlichen von einem Ankerpunkt (A) zu dem anderen Ankerpunkt (A) oder zu dem Symbolelement (5) reicht,
wobei das Bezugselement (6) bevorzugt eine Linie, oder eine linienförmige Fläche oder ein linienförmiges Volumen ist.

5. Bauteilelement (2) nach Anspruch 3 oder 4, wobei das Informationselement (4) ein Funktionselement (F) aufweist, das eine Anzahl von vorgegebenen Parametern des CAD-Programms abfragt und eine Darstellung einer Anzahl von Symbolelementen (5) und/oder Bezugselementen (6) auf den abgefragten Werten der vorgegebenen Parameter basiert,
wobei das Funktionselement (F) bevorzugt dazu ausgelegt ist
- eine Streckenlänge zwischen zwei Ankerpunkten (A) zu ermitteln, und Symbolelemente (5) als Zeichenkette entsprechend des ermittelten Wertes der Streckenlänge darzustellen und/oder Bezugselemente (6) entsprechend einer Distanz zwischen den Ankerpunkten (A) darzustellen, und/oder
- eine Position eines Ankerpunktes (A) zu ermitteln, und Symbolelemente (5) als Zeichenkette entsprechend der ermittelten Position darzustellen und/oder Bezugselemente (6) in Form eines auf die ermittelte Position deutenden Elements darzustellen, und/oder
- einen gewählten Maßstab oder einen gewählten Betrachtungsabstand zum CAD-Objekt zu ermitteln, und die Größe von Symbolelementen (5) und/oder Bezugselementen (6) in Abhängigkeit von dem ermittelten Wert festzulegen und diese Elemente entsprechend darzustellen, und/oder
- eine von einem CAD-Bauteil (3) unabhängige Information darzustellen.

6. Bauteilelement (2) nach Anspruch 5, umfassend eine Funktion, welche einen ermittelten Wert in eine Anzahl von einzelnen Zeichen zerlegt und für jedes Zeichen ein Symbolelement (5) auswählt, dessen Darstellung dem Zeichen entspricht, und wobei jedem Typ der Zeichen bevorzugt ein individueller Zeichenwert zugewiesen wird und die Auswahl eines Symbolelements (5) auf dem Zeichenwert basiert,
bevorzugt wobei das Bauteilelement (2) eine Funktion umfasst, die ein Symbolelement (5) gemäß einem Zeichen, insbesondere dessen Zeichenwerts
- aus einer Liste auswählt, und/oder
- im CAD-Raum als unsichtbares Symbolelement (5) auswählt und sichtbar macht, bevorzugt indem ein an der entsprechenden Stelle platziertes Symbolelement (5) durch Setzen einer Information als sichtbar deklariert wird oder indem ein Symbolelement (5) an eine vorgegebene Stelle verschoben wird und dort sichtbar gemacht wird, bevorzugt durch Bilden einer Schnittmenge mit einem vorher dort platzierten Körper,
- in den CAD-Raum an eine vorgegebene Stelle kopiert wird.

7. Bauteilelement (2) nach Anspruch 6, wobei eine Mehrzahl von Symbolelementen (5) unterschiedlicher Typen von Zeichen, bevorzugt die Ziffern von 0 bis 9 oder die Schriftzeichen eines Alphabets, als Block relativ zu einem gemeinsamen Ankerpunkt (A) angeordnet sind, insbesondere an derselben Position, und zunächst im Raum unsichtbar oder visuell nicht aktiviert sind und bei Auswahl eines Zeichens das Zeichen im Raum dargestellt wird, bevorzugt an seiner Position oder die Information des Symbolelements (5) übernehmend an einer anderen Position.

8. CAD-Struktur (1) umfassend mindestens ein Bauteilelement (2) nach einem der vorangehenden Ansprüche, wobei mindestens ein Ankerpunkt (A) des Bauteilelements (2) an einem Punkt des CAD-Bauteils (3) verankert ist.

9. CAD-Struktur (1) nach Anspruch 8, wobei das Informationselement (4) des Bauteilelements (2) eine Eigenschaft des CAD-Bauteils (3) repräsentiert, und bevorzugt eine Bezeichnung für das CAD-Bauteil (3) angibt oder eine Bemaßung für das CAD-Bauteil (3) angibt.

10. Verfahren zur Erstellung einer CAD-Struktur (1) nach einem der Ansprüche 8 oder 9 umfassend die Schritte:
- Erstellen einer CAD-Struktur (1) mittels eines CAD-Programms aus CAD-Bauteilen (3),
- Auswählen eines Bauteilelements (2) nach einem der Ansprüche 1 bis 7,
- Verankern mindestens eines Ankerpunktes (A) des ausgewählten Bauteilelements (2) mit einem Punkt der CAD-Struktur (1).

11. Verfahren nach Anspruch 10, wobei nach dem Verankern die CAD-Struktur (1) manipuliert wird, insbesondere bewegt oder verformt, bevorzugt extrudiert, sodass jeder Ankerpunkt (A) des Bauteilelements (2), der mit einem Punkt des Bauteils verankert ist, seine Position mit dem betreffenden Punkt verändert, bevorzugt wobei sich eine Bemaßung entsprechend dem Abstand zweier Ankerpunkte (A) automatisch ändert, wenn sich deren Abstand ändert und automatisch das Informationselement (4) an den veränderten Wert angepasst wird.

12. Verfahren nach Anspruch 10 oder 11, umfassend die Schritte:
- Bereitstellen einer Vielzahl von Symbolelementen (5) in Form von Zeichen in einer Liste oder einem Raum,
- Abfragen einer Anzahl von vorgegebenen Parametern des CAD-Programms und Erhalten einer Anzahl von Parameterwerten in Form von Zeichenketten,
für jeden Parameterwert der Anzahl von Parameterwerten
- Zerlegen der Zeichenkette des Parameterwerts in einzelne Zeichen,
- Auswahl von Symbolelementen (5), die den Zeichen entsprechen,
- Anordnen der Symbolelemente (5) in Form einer Zeichenkette, die der Zeichenkette des Parameterwerts entspricht, so dass die Symbolelemente (5) sichtbar im Informationselement (4) des Bauteilelements (2) vorliegen.

13. Computerprogrammprodukt mit einem CAD-Programm, welches direkt in eine Speichereinrichtung einer Recheneinrichtung ladbar ist und eine Funktion zur Generierung von Bauteilelementen (2) gemäß einem der Ansprüche 1 bis 7 umfasst.
